(19) Europäisches Patentamt
European Patent Office
Office européen des brevets

(11) Veröffentlichungsnummer: **0 209 748**
**B1**

(12) # EUROPÄISCHE PATENTSCHRIFT

(45) Veröffentlichungstag der Patentschrift: **29.11.89**

(51) Int. Cl.[4]: **C 23 C 18/18**

(21) Anmeldenummer: **86108644.5**

(22) Anmeldetag: **25.06.86**

(54) **Verfahren zur chemischen Behandlung von Keramikkörpern mit nachfolgender Metallisierung.**

(30) Priorität: **04.07.85 DE 3523958**

(43) Veröffentlichungstag der Anmeldung: **28.01.87 Patentblatt 87/5**

(45) Bekanntmachung des Hinweises auf die Patenterteilung: **29.11.89 Patentblatt 89/48**

(84) Benannte Vertragsstaaten: **AT BE CH DE FR GB IT LI LU NL SE**

(56) Entgegenhaltungen:
**EP-A- 0 128 476**
**FR-A- 2 116 376**

(73) Patentinhaber: **Licentia Patent-Verwaltungs-GmbH, Theodor-Stern-Kai 1, D-6000 Frankfurt/Main 70 (DE)**

(72) Erfinder: **Bogenschütz, August-Friedrich, Dr.rer.nat, Beethovenstrasse 10, D-7931 Oberdischingen (DE)**
Erfinder: **Jostan, Josef L., Dr.rer.nat., Haslacherweg 21, D-7900 Ulm (DE)**
Erfinder: **Ostwald, Robert, Dr.-Ing., Hasensteige 8, D-7900 Ulm (DE)**

(74) Vertreter: **Schulze, Harald Rudolf, Dipl.-Ing. et al, Licentia Patent-Verwaltungs-GmbH Theodor-Stern-Kai 1, D-6000 Frankfurt/Main 70 (DE)**

**EP 0 209 748 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zur stromlos chemischen Metallisierung eines Keramikkörpers gemäß dem Oberbegriff des Patentanspruchs 1. Die Erfindung betrifft insbesondere in einer Alkalihydroxidschmelze behandelte Keramikplatten, die durch nachfolgende Metallisierungen zu elektrischen Schaltungen weiterverarbeitet werden.

Keramikkörper werden metallisiert, um deren funktionelle Eigenschaften zu verändern, zu verbessern oder zu vermehren, wie z.B. die elektrische oder die Wärmeleitfähigkeit, die Korrosionsbeständigkeit, die Verschleißfestigkeit oder auch die dekorativen Eigenschaften. Bei derartigen Metallisierungen ist immer die Haftfestigkeit der Metallauflage zur Keramik von besonderer Bedeutung. Die Haftung der Schichten kommt, stark verallgemeinert, entweder durch relativ schwache Wechselwirkungen zwischen Schicht- und Unterlagematerial (sog. «Van der Waals-Kräfte») oder durch chemische Bindungen oder auch durch mechanische Verankerungen oder durch eine Kombination dieser Beiträge zustande. Die Anteile dieser einzelnen Beiträge hängen im besonderen Maß von der Vorbehandlung der Keramiksubstrate und dem gewählten Metallisierungssystem ab.

Zur Metallisierung von Keramikkörpern, insbesondere von Keramikplatten für Anwendungen in der Elektrotechnik für Leiterplatten und dergleichen, sind einige oft kostspielige Verfahren bekannt, wie beispielsweise das Einbrennen siebgedruckter Edelmetallpasten für sogenannte Dickschichtschaltungen oder die Herstellung von sogenannten Dünnfilmschaltungen durch Vakuumbedampfung oder Kathodenzerstäubung. Diese Verfahren sind nicht nur aufgrund ihrer Unwirtschaftlichkeit auf bestimmte Anwendungsfälle beschränkt, sondern auch aufgrund verschiedener verfahrensbedingter ungünstiger Eigenschaften der damit hergestellten Metallisierungen. So sind in der Dünnfilmtechnik für Gold- oder Kupferschichten haftvermittelnde Fremdschichten aus Chrom, Titan oder Molybdän erforderlich; in der Dickschichttechnik haben die Leitermaterialien durch eingelagerte Glasbestandteile eine stark herabgesetzte Leitfähigkeit und können darüber hinaus aufgrund der Siebdrucktechnik auch nicht wesentlich kleiner als mit einer Bahnbreite von ungefähr 200 µm ausgeführt werden.

Es hat in der Vergangenheit nicht an Versuchen gefehlt, Leiter aus einem reinen Metall, vor allem aus Kupfer, unmittelbar auf Keramikoberflächen aufzubringen, da diese Leiter eine größere Leitfähigkeit haben und daher einen geringeren Leiterbahnquerschnitt erfordern. Ein solches Verfahren basiert auf der stromlos-chemischen bzw. galvanischen Abscheidung von Kupfer auf einer mit katalytisch wirksamen Keimen belegten Keramikoberfläche. Bei bekannten Verfahren ist entweder die Haftfestigkeit der Kupferschichten nicht ausreichend oder die Kupferschichten sind zu fehlerhaft, um sich zur zuverlässigen Herstellung feiner Leiterbahnmuster zu eignen.

Der Erfindung liegt daher die Aufgabe zugrunde, ein gattungsgemäßes Verfahren anzugeben, das in kostengünstiger und zuverlässiger Weise die Ausbildung einer gleichmäßigen und haftfesten Kupferschicht auf einer Keramikunterlage ermöglicht, wobei eine Schälfestigkeit von mindestens 0,4 N/mm erreicht wird, und das unter Beibehaltung dieser Schälfestigkeit eine Ausbildung einer fein strukturierten Kupferschicht ermöglicht, insbesondere bei einer industriellen Massenfertigung von Leiterplatten.

Diese Aufgabe wird durch die im kennzeichnenden Teil des Patentanspruchs 1 angegebenen Merkmale gelöst. Zweckmäßige Ausgestaltungen und/oder Weiterbildungen sind den Unteransprüchen zu entnehmen.

Die Erfindung geht aus von der Erkenntnis, daß eine entscheidende Voraussetzung für eine gleichmäßige und zuverlässig hohe Belegungsdichte von katalytischen Keimen sowie eine gleichmäßig hohe Haftfestigkeit der stromlos-chemisch abgeschiedenen Kupferschicht darin besteht, eine bezüglich Reinigung, Benetzbarkeit und aufrauhenden Ätzangriff der Keramikoberfläche reproduzierbare Vorbehandlung zu erreichen, was in bekannten Verfahren unberücksichtigt ist.

Die Erfindung wird im folgenden anhand von Ausführungsbeispielen näher erläutert unter Bezugnahme auf eine Zeichnung.

Die Erfindung beruht darauf, daß insbesondere die sogenannte «glasartige Brennhaut», welche die meisten Keramik-Qualitäten chemisch inert macht, reproduzierbar entfernt wird. Nach diesem Verfahren werden die Keramikoberflächen nicht nur gereinigt, sondern vielmehr durch einen Abtragungsprozeß chemischer Art aktiviert, damit chemische Bedingungen zu den Oberflächen freigelegter Keramikkristalle erfolgen können. Dieser Abtragungsprozeß darf die Oberflächen aber weder zu stark aufrauhen, noch das Materialgefüge lockern, da anderenfalls die erforderlichen mechanischen Verankerungen zu leicht ausbrechen. Ein chemischer Ätzprozeß, durch den primär die «glasartige Brennhaut» entfernt wird, ist daher am geeignetsten. Für das in der Elektronik am meisten angewandte Keramik-Substratmaterial Aluminiumoxid sind aus der Literatur (vgl. z.B. R. Bock: Aufschlußmethoden der anorganischen und organischen Chemie, Verlag Chemie, Weinheim/Bergstraße, 1972) eine Reihe von Ätzmitteln bekannt, so z.B. Phosphor-, Schwefel-, Salpeter- und Flußsäure oder Ammoniumhydrogenfluorid sowie auch Natronlauge oder eine Natriumhydroxid-Schmelze. Die Säuren erweisen sich aber in der Regel als zu wenig wirksam, während die Alkalien erst bei sehr hoher Temperatur, dann aber zu stark oder ungleichmäßig, die Keramikoberfläche angreifen. Wird das z.B. aus der DE-OS 3 150 399 oder EP-A-128 476 bekannte Verfahren einer Tauchbeschichtung mit Natronlauge angewandt, so muß eine derart hergestellte Schicht erst eingetrocknet werden, wobei die Gefahr der Karbonatisierung besteht, und dann bei sehr hoher Temperatur (ca. 500°C) gebrannt werden, wobei die geringen Alkalihydroxidmengen sich ungleichmäßig verteilen und schnell mit der Unterlage abreagieren, so daß kein weiterer Ätzangriff erfolgen kann. Auch bei dem Verfahren einer Tauchbehandlung in einer Schmelze von Natriumhydroxid kann selbst bei über dem Schmelzpunkt von

NaOH (Fp = 318°C) liegenden Temperaturen kein wesentlich stärkerer Ätzangriff erfolgen.

Es wurde gefunden, daß sich der Ätzangriff der NaOH-Schmelze nun in überraschender Weise durch einen relativ geringen Wassergehalt beträchtlich steigern läßt. Es wurde außerdem gefunden, daß sich durch den gesteigerten Ätzangriff die Keramikoberfläche viel stärker und vor allem gleichmäßiger aufrauhen läßt und durch den dadurch erhöhten Anteil der mechanischen Verankerungen bei Metallisierungen eine erhebliche Steigerung der Haftfestigkeit eintritt. Ferner wurde gefunden, daß sich der Grad der Aufrauhung über den Wassergehalt der Schmelze sehr gut steuern läßt. Zur Haftfestigkeitsmessung werden an den verkupferten Keramikproben fotoätztechnisch 1 mm breite Streifen präpariert, und mit einer Zugprüfmaschine wird die Kraft zum senkrechten Abschälen dieser Streifen gemessen. Die Figur zeigt in N/mm gemessene Schälfestigkeiten in Abhängigkeit vom Wassergehalt, gemessen in Gewichtsprozent (Gew.-%), der zur Ätzung verwendeten Natriumhydroxidschmelze. Durch die Steigerung des Ätzangriffs mit bereits geringen Wasserkonzentrationen der NaOH-Schmelze ergibt sich bei einer Erhöhung des Wassergehalts von 0 auf ca. 2% eine Steigerung der Haftfestigkeit von 15 µm dicken Kupferschichten von 0,3 N/mm auf über 0,8 N/mm. Diese Schichtdicke von 15 µm wurde bei allen Schälfestigkeitsmessungen eingehalten.

Die Verstärkung des Ätzangriffs der NaOH-Schmelze auf die $Al_2O_3$-Keramik ist damit zu begründen, daß die chemische Aktivität der Hydroxidschmelze durch den Wassergehalt zunimmt sowie die Löslichkeit der Reaktionsprodukte, also die Bildung von Aluminat, das z.B. nach der Gleichung

$$Al_2O_3 + 3\,H_2O + 2\,OH^- \rightleftharpoons 2\,[Al(OH)_4]^-,$$

das Vorhandensein von Wasser voraussetzt. Eine NaOH-Schmelze befindet sich bezüglich ihres Wassergehalts mit dem Wasserdampfgehalt der über der Schmelze befindlichen Atmosphäre im Gleichgewicht. Dieser ist bei normaler Raumluft so gering, daß der Wassergehalt der Schmelze bei einer Temperatur von 318°C im Gleichgewicht höchstens 1 ‰ beträgt. Dieser geringe Wassergehalt wird bei der Aluminiumoxid-Ätzung durch beispielhafte Aluminatbildung sofort verbraucht, so daß weitere Ätzprozesse mit wasserfreier Schmelze sehr unbefriedigende Resultate erbringen. Es wurde gefunden, daß eine mit einigen Prozenten Wasser angesetzte und frisch angewandte NaOH-Schmelze recht gute Aufrauhungen bewirkt, aber in ihrer Wirkung sehr schwer zu reproduzieren ist. Ein konstanter und zugleich höherer Wassergehalt der NaOH-Schmelze ist dagegen durch eine Gasatmosphäre mit hohem Wasserdampfpartialdruck über der Schmelze zu erzielen. Wird mit dieser Atmosphäre zugleich dafür gesorgt, daß kein Kohlendioxid zur Schmelze gelangen kann, so wird auch deren Karbonatisierung wirksam verhindert. Das Verfahren läßt sich ebenso gut auch mit den übrigen Alkalihydroxiden wie z.B. LiOH und KOH oder Mischungen aus diesen durchführen.

Ein Schutz empfindlicher Keramikteile vor dem Zerspringen durch Temperaturschock bedingte Spannungen sowie eine weitere Steigerung der Ätzrate bzw. der Reproduzierbarkeit gelingt durch eine Vorwärmung der Keramikkörper vorzugsweise in der Schutzgasatmosphäre.

Die Erfindung soll anhand der folgenden Ausführungsbeispiele näher erläutert werden:

*Beispiel 1*

Aluminiumoxid-Keramiksubstrate aus 99,5% $Al_2O_3$ für Dünnschichtschaltungen mit den Abmessungen $50{,}8 \times 25{,}4 \times 0{,}6\ mm^3$ und einer mittleren Rauhigkeit von 0,25 µm werden in einen Trockenschrank auf eine Temperatur vom 250°C vorgewärmt. Aus Natriumhydroxid-Plätzchen und 5% Wasser- wird eine Schmelze bereitet, die bei 330°C homogen ist. In diese Schmelze werden die Keramiksubstrate 20 min lang eingetaucht. Nach dem Herausziehen und Abkühlen der Keramiksubstrate werden diese in einer 2%igen Natronlauge behandelt und anschließend unter fließendem, demineralisiertem Wasser sowie mit Ultraschall-Unterstützung gründlich gespült. Die getrockneten Proben zeigen eine mittlere Rauhigkeit von ungefähr 0,5 µm.

Zwecks anschließender stromlos chemischer Metallisierung werden die Substrate nacheinander in eine Zinn(II)chlorid-Lösung in Wasser und in eine Palladiumchlorid-Lösung getaucht sowie abschließend in Wasser gespült, um in bekannter Weise mit katalytischen Keimen belegt zu werden. Es erfolgt dann die stromlos-chemische Abscheidung einer ungefähr 0,3 µm dicken Kupfer-Basisschicht aus einem derzeit handelsüblichen chemischen Kupfer-Formaldehyd-Bad sowie nach der Spülung die Verstärkung der Kupferschicht auf ca. 15 µm in einem derzeit handelsüblichen galvanischen Kupfersulfat-Bad.

Zur Haftfestigkeitsprüfung werden an einer Keramikprobe fotoätztechnisch 1 mm breite Streifen präpariert, und mit einer Zugprüfmaschine wird die Kraft zum senkrechten Abschälen dieser Streifen gemessen. Es wird dabei eine Schälkraft von ungefähr 0,7 N/mm festgestellt. Ohne Vorbehandlung in wasserhaltiger NaOH-Schmelze ist die Haftung der Kupferschicht ungleichmäßig und weist allenfalls eine Schälkraft von 0,1 N/mm auf.

*Beispiel 2*

Aluminiumoxid-Keramiksubstrate, wie in Beispiel 1, werden nach einer Vorwärmung auf 250°C 20 min lang in eine Natriumhydroxid-Schmelze getaucht, über welche zuvor 2 Std. lang ein Stickstoff-Wasserdampfstrom geleitet wurde, der durch Erwärmung von Stickstoff auf eine Temperatur von 300°C in einem beheizten Rohr und Leitung über siedendes Wasser hergestellt wurde. Die Temperatur der Schmelze betrug 320°C. Die Keramikproben hatten nach der Spülung und Trocknung eine mittlere Rauhigkeit von ungefähr 1,0 µm. Nach der Bekeimung dieser Proben wurde mit ungefähr 0,1 µm Nickel-Phosphor aus einem derzeit handelsüblichen Nickel-Hypophosphit-Bad vormetallisiert und nach der Spülung in einem Kupfersulfatbad auf ungefähr 15 µm Schichtdicke mit Kupfer galvanisch verstärkt. Nach der fotoätztechnischen Herstellung von 1 mm breiten Schälstreifen wurden Schälkräfte von 0,9 N/mm gemessen.

**Patentansprüche**

1. Verfahren zur stromlos chemischen Metallisierung eines Keramikkörpers, dessen Oberfläche nach einer Behandlung mit einer Alkalihydroxidschmelze stromlos chemisch insbesondere mit Kupfer metallisiert wird, so daß daraus eine elektrische Schaltung herstellbar wird, dadurch gekennzeichnet,

— daß der Keramikkörper zunächst vorgewärmt wird,

— daß der vorgewärmte Keramikkörper anschließend während einer Zeitdauer von 1 s bis 60 min, behandelt wird in einer wasserhaltigen Alkalihydroxidschmelze, deren Wassergehalt eingestellt und während der Behandlung konstant gehalten wird,

— daß die Behandlung in einer wasserdampfhaltigen Schutzgasatmosphäre, durch die insbesondere eine Karbonatisierung der Alkalihydroxidschmelze vermieden und ein konstanter Wassergehalt in der Schmelze aufrecht erhalten wird, durchgeführt wird und

— daß der mit der Alkalihydroxidschmelze benetzte Keramikkörper anschließend mindestens bis zur Schmelztemperatur, des Alkalihydroxids erwärmt wird, sowie einer Spülbehandlung und einer chemogalvanischen Metallisierung unterzogen wird.

2. Verfahren nach Anspruch 1, dadurch gekennzeichnet, daß der Keramikkörper vorgewärmt wird auf eine Temperatur, die gleich oder wenig kleiner ist als die Temperatur der Alkalihydroxidschmelze.

3. Verfahren nach einem der vorhergehenden Ansprüche, dadurch gekennzeichnet, daß in der Alkalihydroxidschmelze ein Wassergehalt, der in einem Bereich von 1 bis 5 Gew.-% liegt, eingestellt wird.

4. Verfahren nach einem der vorhergehenden Ansprüche, dadurch gekennzeichnet, daß die Behandlung des Keramikkörpers mit der Alkalihydroxidschmelze durch Tauchen, Sprühen, Walzen oder andere mechanische Verfahren erfolgt.

5. Verfahren nach einem der vorhergehenden Ansprüche, dadurch gekennzeichnet, daß die Behandlung in einer wasserdampfhaltigen Schutzgasatmosphäre, die Stickstoff oder ein Edelgas enthält, durchgeführt wird.

6. Verfahren nach einem der vorhergehenden Ansprüche, dadurch gekennzeichnet, daß die Nachbehandlung des weiteren in einer Spülung der Keramikkörper in einer Lösung besteht, die einen pH-Wert zwischen pH = 8 und pH = 11 aufweist.

7. Verfahren nach einem der vorhergehenden Ansprüche, dadurch gekennzeichnet, daß die Nachbehandlung des weiteren in einer Spülung der Keramikkörper in demineralisiertem Wasser und einer Trocknung in einem Stickstoffstrom besteht.

8. Verfahren nach einem der vorhergehenden Ansprüche, dadurch gekennzeichnet, daß der Keramikkörper aus den Stoffgruppen der Oxide, Nitride, Carbide, Boride und Silicide besteht.

**Claims**

1. Process for the current-free chemical metallising of a ceramic body, the surface of which is metallised, in particular with copper, chemically without current after a treatment with an alkali hydroxide bath so that an electrical circuit is manufacturable therefrom, characterised thereby,

— that the ceramic body is initially preheated,

— that the preheated ceramic body is subsequently treated for a time duration of 1 second to 60 minutes in an aqueous alkali hydroxide bath, the water content of which is set and kept constant during the treatment,

— that the treatment is performed in a protective gas atmosphere, which contains water vapour and by which particularly a carbonation of the alkali hydroxide bath is avoided and a constant water content is maintained in the bath, and

— that the ceramic body wetted by the alkali hydroxide bath is subsequently heated to at least the melting temperature of the alkali hydroxide as well as subjected to a rinsing treatment and a chemically galvanic metallising.

2. Process according to claim 1, characterised thereby, that the ceramic body is preheated to a temperature which is equal to or little less than the temperature of the alkali hydroxide bath.

3. Process according to one of the preceding claims, characterised thereby, that a water content, which lies in a range of 1 to 5% by weight, is set in the alkali hydroxide bath.

4. Process according to one of the preceding claims, characterised thereby, that the treatment of the ceramic body by the alkali hydroxide bath takes place through dipping, spraying, rolling or other mechanical processes.

5. Process according to one of the preceding claims, characterised thereby, that the treatment is performed in a protective gas atmosphere which contains water vapour and either nitrogen or an inert gas.

6. Process according to claim 1, characterised thereby, that the finishing treatment furthermore consists in a rinsing of the ceramic body in a solution which displays a pH value between pH = 8 and pH = 11.

7. Process according to one of the preceding claims, characterised thereby, that the finishing treatment furthermore consists in a rinsing of the ceramic body in demineralised water and a drying in a current of nitrogen.

8. Process according to one of the preceding claims, characterised thereby, that the ceramic body consists of the substance groups of the oxides, nitrides, carbides, borides and silicides.

**Revendications**

1. Procédé pour la métallisation chimique sans courant d'une pièce de céramique, dont la surface, après un traitement par un bain d'hydroxyde alcalin fondu, est métallisée chimiquement sans courant, en particulier par le cuivre, de sorte qu'elle puisse servir à la fabrication d'un circuit électrique, caractérisé en ce que

— la pièce en céramique est d'abord préchauffée,

— la pièce en céramique préchauffée est ensuite

traitée pendant une durée de 1 s à 60 min dans un bain d'hydroxyde alcalin fondu contenant de l'eau, dont la teneur en eau est réglée et maintenue constante pendant le traitement,

— le traitement est mis en oeuvre dans une atmosphère de gaz protecteur contenant de la vapeur d'eau, qui évite en particulier une carbonatation du bain d'hydroxyde alcalin et maintient une teneur en eau constante dans le bain, et

— la pièce de céramique mouillée par le bain d'hydroxyde alcalin est ensuite chauffée au moins jusqu'à la température de fusion de l'hydroxyde alcalin, et soumise à un traitement de rinçage et à une métallisation chimiogalvanique.

2. Procédé selon la revendication 1, caractérisé en ce que la pièce de céramique est chauffée à une température qui est égale ou peu inférieure à la température du bain d'hydroxyde alcalin fondu.

3. Procédé selon l'une des revendications précédentes, caractérisé en ce que l'on ajuste dans le bain d'hydroxyde alcalin fondu une teneur en eau qui est comprise dans une gamme de 1 à 5% en poids.

4. Procédé selon l'une des revendications précédentes, caractérisé en ce que le traitement de la pièce de céramique par le bain d'hydroxyde alcalin fondu s'effectue par immersion, pulvérisation, laminage ou d'autres procédés mécaniques.

5. Procédé selon l'une des revendications précédentes, caractérisé en ce que le traitement est mis en oeuvre dans une atmosphère de gaz protecteur contenant de la vapeur d'eau qui contient de l'azote ou un gaz rare.

6. Procédé selon l'une des revendications précédentes, caractérisé en ce que le traitement ultérieur consiste en outre en un rinçage de la pièce de céramique dans une solution qui présente un pH compris entre 8 et 11.

7. Procédé selon l'une des revendications précédentes, caractérisé en ce que le traitement ultérieur consiste en outre en un rinçage de la pièce de céramique dans l'eau déminéralisée et un séchage dans un courant d'azote.

8. Procédé selon l'une des revendications précédentes, caractérisé en ce que la pièce de céramique est constituée des groupes de substances des oxydes, nitrures, carbures, borures et siliciures.

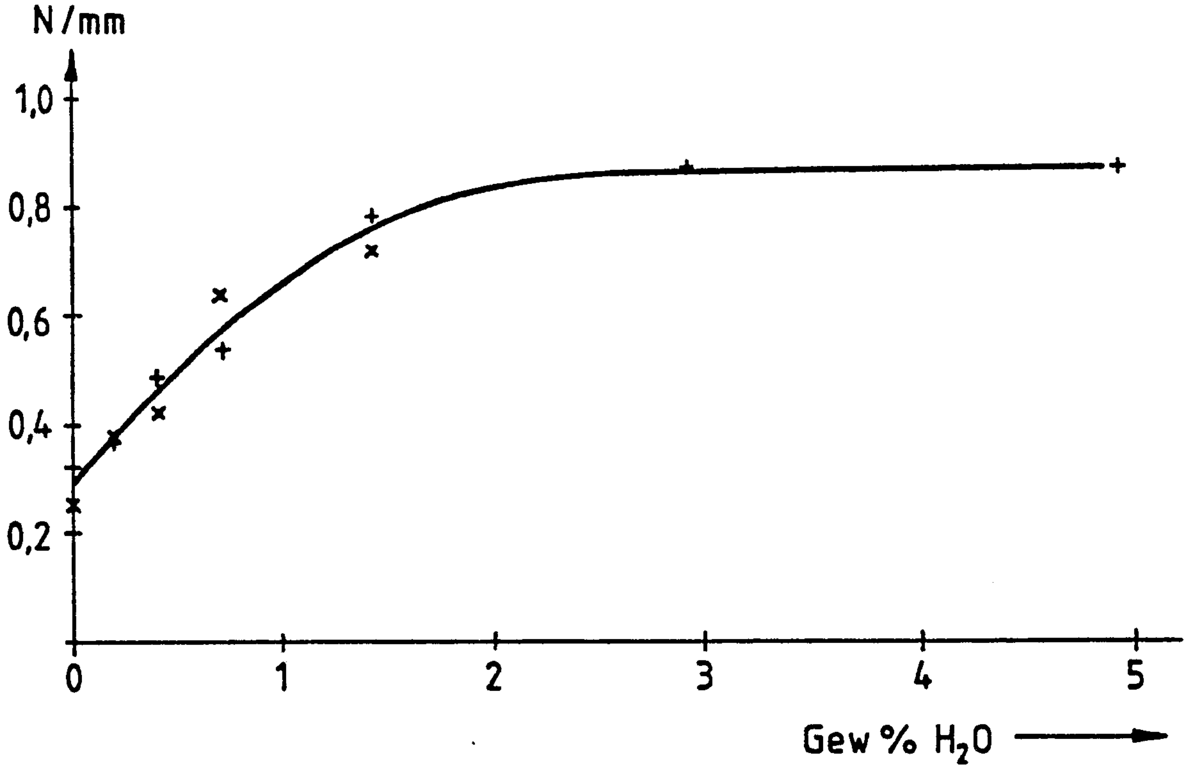
N/mm
1,0
0,8
0,6
0,4
0,2
0
1
2
3
4
5
Gew % $H_2O$